Europäisches Patentamt

European Patent Office

Office européen des brevets

(19)

(11) Veröffentlichungsnummer : **0 324 812 B1**

(12) **EUROPÄISCHE PATENTSCHRIFT**

(45) Veröffentlichungstag der Patentschrift :
**09.09.92 Patentblatt 92/37**

(51) Int. Cl.$^5$ : **H01L 21/205, C30B 25/02, C30B 29/40**

(21) Anmeldenummer : **88905675.0**

(22) Anmeldetag : **30.06.88**

(86) Internationale Anmeldenummer :
**PCT/DE88/00401**

(87) Internationale Veröffentlichungsnummer :
**WO 89/00335 12.01.89 Gazette 89/02**

(54) MATERIALSPARENDES VERFAHREN ZUR HERSTELLUNG VON MISCHKRISTALLEN.

(30) Priorität : **30.06.87 DE 3721638**

(43) Veröffentlichungstag der Anmeldung :
**26.07.89 Patentblatt 89/30**

(45) Bekanntmachung des Hinweises auf die
Patenterteilung :
**09.09.92 Patentblatt 92/37**

(84) Benannte Vertragsstaaten :
**AT BE CH DE FR GB IT LI LU NL SE**

(56) Entgegenhaltungen :
**FR-A- 2 356 271
FR-A- 2 501 908
GB-A- 1 042 933
US-A- 3 925 119
Journal of The Electrochemical Society, vol.
113, No. 7, July 1966 (Princeton, US), J.J. Tietjen et al.: "The preparation andproperties of
vapor-deposited epitaxial GaAs1-xPx using
arsine and phosphine", see pages 724-728**

(56) Entgegenhaltungen :
**Journal of Crystal Growth, vol. 71, No. 1, Janu-
ary-February 1985, Elsevier Science Publishers B.V. (Amsterdam, NL), K.P.Quinlan et al.:
"Formation of a limiting composition of Ga-
XIn1-xAs in the VPE-hydride technique using a
continuous hydrogenchloride etch", pages
246-248, see the whole document
Scientific and Technical Journal, vol. 10, No. 2,
June 1974, K. Dazai et al.: "Vapor phase epitaxial growth of GaAs in annitrogen atmosphere", pages 125-143, see pages 126, 127,
paragraph 2 "Growth system and experimental procedure", fig. 1**

(73) Patentinhaber : **AIXTRON GMBH
Jülicher Strasse 336
W-5100 Aachen (DE)**

(72) Erfinder : **JÜRGENSEN, Holger
Melatenerstr. 56
W-5100 Aachen (DE)**
Erfinder : **GRÜTER, Klaus
Malmedeyer Str. 8
W-5100 Aachen (DE)**
Erfinder : **DESCHLER, Marc
Karl-Friedrich-Str. 38
W-5100 Aachen (DE)**
Erfinder : **BALK, Pieter
Pommerotter Weg 43
W-5100 Aachen (DE)**

(74) Vertreter : **Münich, Wilhelm, Dr.
Kanzlei Münich, Steinmann, Schiller
Willibaldstrasse 36/38
W-8000 München 21 (DE)**

## Beschreibung

## Technisches Gebiet

Die Erfindung bezieht sich auf ein materialsparendes Verfahren zur Herstellung von Mischkristallen und insbesondere von III-V-Halbleitern, bei dem in einem Reaktor wenigstens ein Bestandteil des Mischkristalls aus einer Quelle in die Gasphase, die als Reaktionsgas HCl sowie ein Trägergas aufweist, überführt, mit dem oder den anderen gasförmigen Bestandteilen des Mischkristalls gemischt, zu einem Substrat transportiert und auf dem Substrat niedergeschlagen wird.

## Stand der Technik

Verfahren gemäß dem Oberbegriff des Anspruchs 1 werden auch als Tietjen-Prozeß bezeichnet und finden insbesondere dann Anwendung, wenn besonders hohe Anforderungen an die Qualität und an die Homogenität der aufgebrachten Mischkristallschichten gestellt werden.

In der Vergangenheit sind derartige Verfahren insbesondere zur Herstellung von III-V-Halbleitern, wie GaAs, InGaAs, InP-Schichten, aber auch zur Herstellung von II-VI-Mischkristallen eingesetzt worden. Dabei wurden in der Regel Totaldrücke im Reaktor zwischen 100 und 1000 mbar eingestellt und Wachstumsraten zwischen typischerweise 1 μm/h und maximal 30 μm/h erzielt. Dabei erhält man die von Epitaxieverfahren bekannte Abhängigkeit zwischen Totaldruck und Wachstumsrate der Schicht, nämlich ein monotones Absinken der Wachstumsrate mit abnehmendem Druck.

Eine Erhöhung des Partialdrucks über ca 1000 mbar ergibt keine wesentliche Erhöhung der Wachstumsgeschwindigkeit, verschlechtert aber die Qualität der hergestellten Schichten.

Ein Verfahren anderer Gattung, bei dem als Reaktionsgas $AsCl_3$ verwendet wird, ist aus der FR-A-2 501 908 bekannt; bei diesem Verfahren erhält man bei einer Druckvariation im oben genannten Druckbereich ähnliche Wachstumsraten wie obenstehend angegeben. Ähnliches gilt auch für das aus der US-A-3 923 119 bekannte Verfahren anderer Gattung als im Oberbegriff des Anspruchs 1 angegeben.

## Darstellung der Erfindung

Der Erfindung liegt die Aufgabe zugrunde, ein Verfahren gemäß dem Oberbegriff des Anspruchs 1 derart weiterzubilden, daß homogene Mischkristalle mit weiterhin guter Qualität mit großen Wachstumsraten hergestellt werden können, die eine wirtschaftliche Herstellung ermöglichen.

Eine erfindungsgemäße Lösung dieser Aufgabe ist mit ihren Weiterbildungen in den Patentansprüchen gekennzeichnet.

Überraschender Weise erhält man bei Verfahren gemäß dem Oberbegriff des Anspruchs 1, also bei Verfahren, bei denen HCl als Reaktionsgas verwendet wird, durch eine Verringerung des Gesamtdrucks im Reaktor auf Werte deutlich unter die bisher gebräuchliche untere Grenze für den Totaldruck Wachstumsraten, die über einen weiten Bereich bis zu Werten variiert werden können, die mehr als den Faktor 10 über den bisher mit gattungsgemäßen Verfahren erzielbaren Werten liegen.

Besonders überraschend ist jedoch, daß vermutlich aufgrund eines andersartigen thermodynamischen und thermokinetischen Verhaltens die Wachstumsrate mit sinkendem Gesamtdruck ansteigt. Typischerweise kann man die Wachstumsraten zwischen ca. 1 μm/h und ca. 500 μm/h dadurch variieren, daß der Totaldruck zwischen ca 80 mbar und ca 1 mbar variiert wird.

Das erfindungsgemäße Verfahren hat nicht nur den Vorteil, daß hohe Wachstumsraten erzielt werden können, die eine wirtschaftliche Herstellung von Mischkristallen, beispielsweise von III-V-Halbleiter-Mischkristallen erlauben. Damit eignet sich das erfindungsgemäße Verfahren nicht nur zur Herstellung dünner Schichten, sondern auch zur Herstellung des Substrats, auf dem die dünnen Schichten aufgebracht werden. Da die Substratherstellung damit ohne mechanische Bearbeitung möglich wird, können auch sehr empfindliche Systeme, wie InGaAs mit dem erfindungsgemäßen Verfahren wirtschaftlich hergestellt werden.

Darüberhinaus sind die mit dem erfindungsgemäßen Verfahren erhaltenen Schichten extrem homogen und weisen hervorragende elektrische und optische Eigenschaften auf. Man erhält eine hervorragende Morphologie und insbesondere spiegelnde Oberflächen.

Weiterhin zeigt das erfindungsgemäße Verfahren eine hohe Ausbeute, so daß der Einsatz von Gasen und insbesondere von Giftgasen wesentlich reduziert werden kann. Hierdurch wird die Sicherheit bei der Schichtherstellung bei gleichzeitiger weiterer Reduzierung der Kosten erhöht.

Das erfindungsgemäße Verfahren ermöglicht es - wie bereits ausgeführt - durch eine Variation des Gesamtdrucks um ca 2 Zehnerpotenzen die Wachstumsrate um ca. 3 Zehnerpotenzen zu variieren. Darüberhin-

EP 0 324 812 B1

aus ermöglicht es das erfindungsgemäße Verfahren jedoch, bei in dem erfindungsgemäßen Bereich konstant gehaltenem Gesamtdruck durch Variation anderer Parameter die Wachstumsrate ebenfalls in weiten Bereichen zu variieren. Dies ist in der Praxis von großer Bedeutung, da hierdurch eine sehr genaue Einstellung der Wachstumsrate möglich wird.

Beispiele hierfür sind in den Ansprüchen 2 und 4 gekennzeichnet.

Erfindungsgemäß kann beispielsweise der HCl-Partialdruck zwischen ca. $5*10^{-6}$bar und ca. $5*10^{-3}$bar variiert werden. Hierdurch kann die Wachstumsgeschwindigkeit bei konstantem Gesamtdruck um mehr als eine Zehnerpotenz variiert werden (Anspruch 2).

Bei Verfahren gemäß dem Oberbegriff des Anspruchs 1 werden das oder die Elemente der V.-Hauptguppe häufig als Wasserstoffverbindungen zugeführt, wie dies im Anspruch 3 angegeben ist.

Im Anspruch 4 ist gekennzeichnet, daß in diesem Falle der der Partialdruck der als Wasserstoffverbindungen vorliegenden Elemente der V.-Hauptgruppe zwischen ca. $10^{-4}$bar und $10^{-2}$bar variiert werden kann, wodurch man eine Variation der Wachstumsgeschwindigkeit um mehr als 2 Zehnerpotenzen erhält.

Das erfindungsgemäße Verfahren eignet sich zur Herstellung von III-V-Mischkristallen sowie auch zur Herstellung von II-VI-Mischkristallen.

Bei III-V-Mischkristallen ist es bevorzugt, daß der oder die aus einer Quelle reagierenden Bestandteile ein oder mehrere Elemente der III. Hauptgruppe sind.

Bei Verwendung von Gallium (Anspruch 6) als Element der V-Hauptgruppe kann typischerweise die Temperatur der Quelle 600 - 750°C betragen.

Besonders überraschend ist jedoch, daß bei der erfindungsgemäßen Prozessführung als Trägergas anstelle von Wasserstoff ($H_2$) auch Stickstoff ($N_2$) oder Edelgase (Helium, Argon) verwendet werden können. Die Ursache hierfür ist die durch die erfindungsgemäße Prozessführung veränderte chemische Reaktion, die den Abscheidungsprozess beeinflußt, so daß während der Epitaxie anstelle von Wasserstoff andere Gase verwendet werden können.

Hierdurch ergeben sich eine Reihe von grundlegenden Vorteilen für den Einsatz in Produktionsprozessen:

Durch den Wegfall von Wasserstoff als Trägergas können keine Knallgasreaktionen mehr stattfinden, so daß die Sicherheit des Systems um ein Vielfaches erhöht wird und insbesondere die Prozessführung nicht mehr explosiv ist.

Durch die Verwendung von $N_2$ anstelle von Wasserstoff können die Verbrauchskosten an Trägergas (99 % des Gasverbrauchs) drastisch reduziert werden, da hochreiner Wasserstoff wesentlich teurer als Stickstoff ist.

Bei gleichbleibend guter Morphologie, d. h. bei spiegelnden Oberflächen steigen beispielsweise bei der Herstellung von GaAs die Wachstumsraten bei Verwendung von Stickstoff als Trägergas um ca. 10 % gegenüber der Verwendung von Wasserstoff an. Gleichzeitig sinkt der Einbau von Verunreinigungen um fast eine Zehnerpotenz, so daß die Hintergrunddotierung im $10^{13}$ cm$^{-3}$. Bereich mit entsprechendem Anstieg der Ladungsträgerbeweglichkeit liegt.

## Kurze Beschreibung der Zeichnung

Die Erfindung wird nachstehend anhand eines Ausführungsbeispiels unter Bezugnahme auf die Zeichnung näher beschrieben, in der zeigen:

Fig. 1 schematisch einen Reaktor zur Durchführung des erfindungsgemäßen Verfahrens,

Fig. 2 die Abhängigkeit der Wachstumsrate vom Gesamtdruck,

Fig. 3 die Abhängigkeit der Wachstumsrate vom HCl-Partialdruck, und

Fig. 4 die Abhängigkeit der Wachstumsrate vom $AsH_3$-Partialdruck.

## Beschreibung eines Ausführungsbeispiels

Im folgenden soll das erfindungsgemäße Verfahren ohne Beschränkung des allgemeinen Erfindungsgedankens exemplarisch für die Herstellung von GaAs-Schichten erläutert werden.

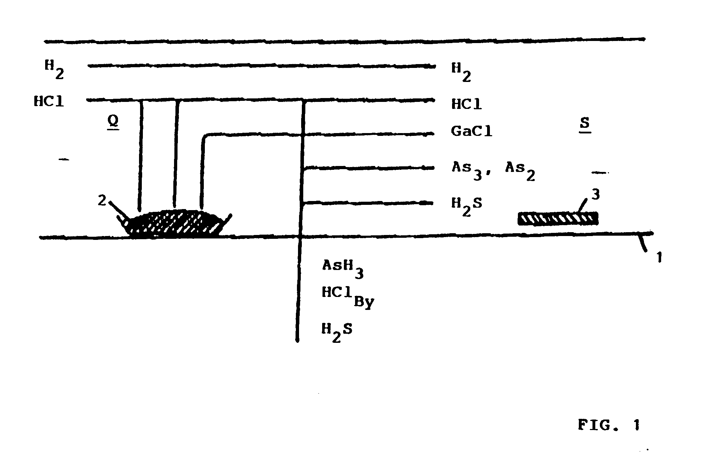

Fig. 1 zeigt schematisch einen Reaktor 1 zur Durchführung des erfindungsgemäßen Verfahrens. In dem Reaktor 1 sind eine Gallium-Quelle 2 und ein Substrat 3 angeordnet. Ferner sind nicht im einzelnen dargestellte Einlaßleitungen für das dosierte Einlassen von $AsH_3$, HCl, $H_2$ oder $N_2$ als Trägergas sowie als Dotiergas $H_2S$ vorgesehen. Ausdrücklich soll darauf hingewiesen werden, daß das erfindungsgemäße Verfahren unabhängig von einer speziellen Dotierung ist, so daß die folgenden Angaben exemplarisch zu verstehen sind.

Ähnliche Ergebnisse würde man beispielsweise erhalten, wenn als Dotiergas Diethylzink verwendet wird.

Entsprechend der Anordnung der einzelnen Elemente weist der Reaktor 1 in an sich bekannter Weise eine Quellenzone Q mit einer Temperatur $T_S$ und eine Substratzone S mit einer Temperatur $T_D$ auf. Die einzelnen Gasströme in dieser Zone sind stark schematisiert Fig. 1 zu entnehmen.

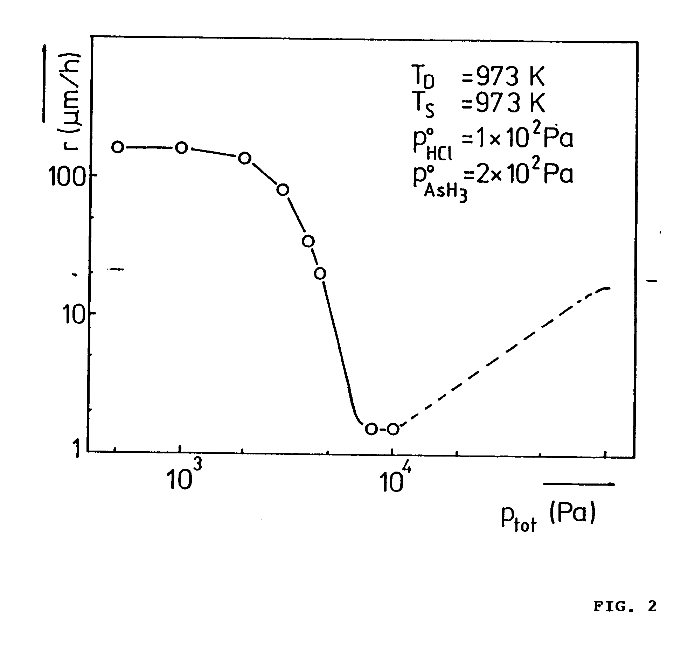

Fig. 2 zeigt die Wachstumsrate r in μm/h als Funktion des Gesamtdrucks $p_{tot}$ in Pa ($10^5$pa = 1bar) bei folgender Parameterwahl:

| | |
|---|---|
| Temperatur $T_S$ der Quelle: | 973 K |
| Temperatur $T_D$ des Substrats: | 973 K |
| Partialdruck $p_{HCl}$: | 100 Pa |
| Partialdruck $p_{AsH3}$: | 200 Pa |

Fig. 2 ist zu entnehmen, daß bei den bisher üblichen Gesamtdrücken $p_{tot} \geqq 100$ mbar (= $10^4$Pa) die Wachstumsrate r mit sinkendem Druck abnimmt. Insgesamt erhält man bei einer Druckzunahme um einer Zehnerpotenz auch eine Zunahme der Wachstumsgeschwindigkeit von einer Zehnerpotenz.

Bei ca. 100 mbar beträgt die Wachstumsgeschwindigkeit 1-2 μm/h, ein insbesondere für industriellen Einsatz sehr kleiner Wert. Deshalb sind in der Vergangenheit Gesamtdrücke unter ca. 100 mbar nicht in Betracht gezogen worden.

Erfindungsgemäß ist jedoch erkannt worden, daß bei Drücken unter 100 mbar überraschenderweise die Wachstumsgeschwindigkeit wieder steil mit negativem Druck-Koeffizientem ansteigt. Erst bei Drücken unter 10 mbar geht die Wachstumsrate r in einen Sättigungswert über, der typischerweise um ca eine Zehnerpotenz höher liegt als die höchste Wachstumsrate bei Drücken im Bereich von ca. 1 bar.

Erfindungsgemäß kann die Wachstumsrate bzw. -geschwindigkeit r nicht nur durch Variation des Gesamtdrucks über einen weiten Bereich variiert werden, sondern auch bei einem konstantem Gesamtdruck in dem erfindungsgemäß gewählten Bereich durch Variation von Partialdrücken.

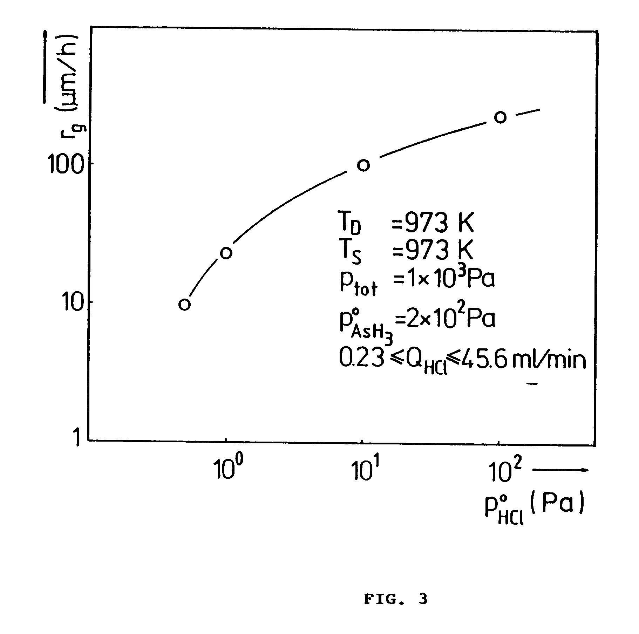

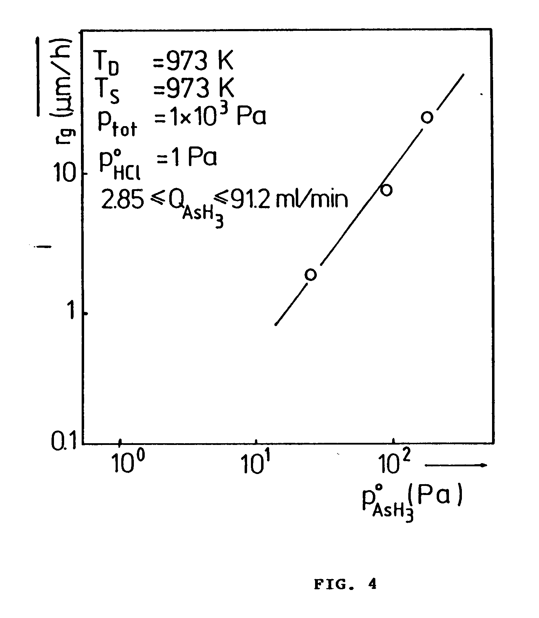

Die Fig. 3 und 4 zeigen hierfür Beispiele. Beiden Beispielen sind folgende Parameter gemeinsam:

$$T_D = 973\,K, \qquad T_S = 973\,K, \qquad p_{tot} = 10\,mbar$$

Bei dem in Fig. 3 dargestellten Beispiel ist die Wachstumsrate r als Funktion des HCl-Partialdrucks und bei dem in Fig. 4 gezeigten Beispiel als Funktion des $AsH_3$-Partialdrucks dargestellt. In den Figuren ist ferner der Volumenfluß-Bereich Q von $AsH_3$ in ml/min sowie der jeweils konstant gehaltene Partialdruck angegeben.

Wie den Figuren 3 und 4 zu entnehmen ist, kann erfindungsgemäß auch bei einem sehr kleinem konstantem Gesamtdruck von beispielsweise 10 mbar und konstanter Temperatur die Wachstumsrate r über ca. 3 Zehnerpotenzen variiert werden. Beispielsweise erhält man bei den oben angegebenen Parametern folgende Werte:

| $p_{HCl}$ | $p_{AsH3}$ | Wachstumsrate | |
|---|---|---|---|
| $10^{-5}$ bar | $0,275*10^{-3}$ bar | 1,6 | μm/h |
| $10^{-3}$ bar | $2,0 \ *10^{-3}$ bar | 277 | μm/h |

Die vorstehenden Zahlenwerte gelten für die Verwendung von Wasserstoff ($H_2$) als Trägergas. Durch die Verwendung von Stickstoff $N_2$ als Trägergas können insbesondere bei der Herstellung von GaAs die Wachstumsraten nochmals um ca. 10 % erhöht werden. Gleichzeitig sinkt der Einbau von Verunreinigungen um fast eine Zehnerpotenz, so daß die erreichbare Hintergrunddotierung im Bereich von $10^{13}$ cm$^{-3}$ liegt. Entsprechend steigt die Ladungsträgerbeweglichkeit an.

Ähnliche Ergebnisse können auch bei der Verwendung von Inertgasen wie Helium oder Argon als Trägergas erzielt werden.

Vorstehend ist die Erfindung anhand von Ausführungsbeispielen ohne Beschränkung des allgemeinen Erfindungsgedankens beschrieben worden, innerhalb dessen selbstverständlich die verschiedensten Modifikationen möglich sind:

Erfindungsgemäß wird bei einem Totaldruck gearbeitet, der wenigstens um den Faktor 2-3 unter dem Wert lieft, bei dem man beim Arbeiten im herkömmlichen Druckbereich Wachstumsraten von weniger als 2 μm/h erhält. Dieser Wert beträgt bei GaAs ca. 100 mbar, bei anderen Schichtsystemen kann er natürlich abweichen. Ferner ist es nicht nur möglich, III-V-Halbleiter herzustellen, sondern auch II-VI-Mischkristalle, Darüberhinaus können mit dem erfindungsgemäßen Verfahren neben binären auch ternäre oder quarternäre Mischkristalle deponiert werden.

In jedem Falle erhält man durch das erfindungsgemäße Verfahren Schichten hervorragender Qualität mit dem zusätzlichen Vorteil, daß bei einer industriellen Fertigung von Bauelementen, deren Schichten bzw. Schichtfolgen in der Dicke start unterschiedlich sind, eine leichte Einstellung der Wachstumsrate ohne großen apparativen Aufwand möglich ist. Darüberhinaus ist die Effizienz des erfindungsgemäßen Verfahrens sehr hoch, so daß sich ein entsprechend geringer Materialeinsatz ergibt. Die hohe Wachstumsgeschwindigkeit ermöglicht nicht nur die Herstellung dünner Schichten, sondern auch die Herstellung von Substraten, so daß sich das erfindungsgemäße Verfahren auch zur Herstellung komplizierter Schichten und Substratsysteme eignet.

**Patentansprüche**

1. Verfahren zur Herstellung von Mischkristallen und insbesondere von III-V-Halbleitern,
   bei dem in einem Reaktor wenigstens ein Bestandteil des Mischkristalls aus einer Quelle in die Gasphase, die als Reaktionsgas HCl sowie ein Trägergas aufweist, überführt, mit dem oder den anderen gasförmigen Bestandteilen des Mischkristalls gemischt, zu einem Substrat transportiert und auf dem Substrat niedergeschlagen wird, dadurch **gekennzeichnet,** daß zur Variation der Wachstumsraten zwischen ca. 1µm/h und ca. 500µm/h der Totaldruck im Reaktor zwischen ca. 80mbar und ca. 1 mbar variiert wird.

2. Verfahren nach Anspruch 1,
   dadurch **gekennzeichnet,** daß der Partialdruck des HCl-Reaktionsgases zwischen ca. $5*10^{-6}$bar und ca. $5*10^{-3}$bar variiert wird.

3. Verfahren nach Anspruch 1 oder 2,
   dadurch **gekennzeichnet,** daß das oder die Elemente der V. Hauptgruppe als Wasserstoffverbindungen zugeführt werden.

4. Verfahren nach einem der Ansprüche 1 bis 3, dadurch **gekennzeichnet,** daß der Partialdruck der als Wasserstoffverbindungen vorliegenden Elemente der V.- Hauptgruppe zwischen ca. $10^{-4}$bar und $10^{-2}$bar variiert wird.

5. Verfahren nach einem der Ansprüche 1 bis 4,
   dadurch **gekennzeichnet,** daß der aus einer Quelle in die Gasphase überführte Bestandteil ein Element der III. Hauptgruppe ist.

6. Verfahren nach Anspruch 5,
   dadurch **gekennzeichnet,** daß das Element Gallium ist.

7. Verfahren nach einem der Ansprüche 1 bis 6,
   dadurch **gekennzeichnet,** daß der in die Gasphase überführte Bestandteil bei einer Temperatur der Quelle von ca. 700°C verdampft wird.

8. Verfahren nach einem der Ansprüche 1 bis 7, dadurch **gekennzeichnet,** daß das Trägergas $N_2$ ist.

**Claims**

1. Process for fabricating mixed crystals and, in particular, III-V semiconductors,
   wherein at least one component of the mixed crystal is transformed from a source into the gaseous phase, which contains HCl as reactant gas as well as a gaseous carrier, is mixed with the or the other gaseous component or components of the mixed crystal, is transferred to a substrate and precipitated on the substrate,
   **characterized** in that the total pressure in the reactor is varied between roughly 80 mbar and 1 mbar approximately so as to vary the growth rate between roughly 1 µm/environ and 500 µm/h approximately.

2. Process according to Claim 1,
   **characterized** in that the partial pressure of the HCl reactant gas is varied between roughly $5 \cdot 10^{-6}$ bar and $5 \cdot 10^{-3}$ bar approximately.

3. Process according to Claim 1 or 2,
   **characterized** in that the element or elements of main group V is or are supplied in the form of hydrogen compounds.

4. Process according to any of claims 1 to 4,

**characterized** in that the partial pressure of the elements of main group V, which are present in the form of hydrogen compounds, is varied between roughly $10^{-4}$ bar and $10^{-2}$ bar.

5. Process according to any of Claims 1 to 4,
**characterized** in that the component transformed from a source into the gaseous phase is an element of main group III.

6. Process according to Claim 5,
**characterized** in that the element is gallium.

7. Process according to any of Claims 1 to 6,
**characterized** in that the component transformed into the gaseous phase is vaporized at a source temperature of roughly 700° °C.

8. Process according to any of Claims 1 to 7,
**characterized** in that the carrier gas is $N_2$.


**Revendications**

1. Procédé de fabrication de solutions solides cristallines, en particulier de semiconducteurs III-V, dans lequel on transforme, dans un réacteur, au moins un composant de la solution solide d'une source en phase gazeuse qui comprend HCl comme gaz réactionnel ainsi qu'un porteur gazeux, on le mélange avec l'autre ou les autres composants gazeux de la solution solide, on le véhicule à un substrat et le précipite sur le substrat,
**caractérisé** en ce que la pression totale dans le réacteur est variée entre 80 mbar environ et 1 mbar environ pour varier le taux de croissance entre 1 $\mu$m/environ et 500 $\mu$m/h environ.

2. Procédé selon la Revendication 1,
**caractérisé** en ce que la pression partielle du gaz réactionnel à HCl est variée entre $5 \cdot 10^{-6}$ bar environ et $5 \cdot 10^{-3}$ bar environ.

3. Procédé selon la Revendication 1 ou 2,
**caractérisé** en ce que l'élément ou les éléments de la $V^{me}$ colonne principale est ou sont amenés sous forme de combinaisons de l'hydrogène.

4. Procédé selon une quelconque des Revendications 1 à 3,
**caractérisé** en ce que la pression partielle des éléments de la $V^{me}$ colonne principale, qui sont présents sous forme de combinaisons de l'hydrogène, est variée entre $10^{-4}$ bar environ et $10^{-2}$ bar.

5. Procédé selon une quelconque des Revendications 1 à 4,
**caractérisé** en ce que le composant transformé d'une source en phase gazeuse est un élément de la $III^{me}$ colonne principale.

6. Procédé selon la Revendication 5,
**caractérisé** en ce que ledit élément est gallium.

7. Procédé selon une quelconque des Revendications 1 à 6,
**caractérisé** en ce que le composant transformé en phase gazeuse est vaporisé à une température de la source de 700 °C environ.

8. Procédé selon une quelconque des Revendications 1 à 7, **caractérisé** en ce que le porteur gazeux est $N_2$.

FIG. 1

FIG. 2

$T_D = 973\,K$
$T_S = 973\,K$
$P_{tot} = 1 \times 10^3\,Pa$
$P^{\circ}_{AsH_3} = 2 \times 10^2\,Pa$
$0.23 \leqslant Q_{HCl} \leqslant 45.6\,ml/min$

$r_g\,(\mu m/h)$

$P^{\circ}_{HCl}\,(Pa)$

**FIG. 3**

FIG. 4

EP 0 324 812 B1